(19) Europäisches Patentamt
European Patent Office
Office européen des brevets

(11) EP 0 716 783 B1

(12) **EUROPÄISCHE PATENTSCHRIFT**

(45) Veröffentlichungstag und Bekanntmachung des Hinweises auf die Patenterteilung:
**15.04.1998 Patentblatt 1998/16**

(21) Anmeldenummer: **94925475.9**

(22) Anmeldetag: **25.08.1994**

(51) Int Cl.[6]: **H03G 7/00**, G06G 7/24

(86) Internationale Anmeldenummer:
**PCT/EP94/02810**

(87) Internationale Veröffentlichungsnummer:
**WO 95/07574 (16.03.1995 Gazette 1995/12)**

(54) **VERSTÄRKERSTUFE MIT EINER DB-LINEAREN AUSGANGSSPANNUNG**

AMPLIFIER STAGE WITH A DB-LINEAR OUTPUT VOLTAGE

ETAGE AMPLIFICATEUR A TENSION DE SORTIE LINEAIRE EN DB

(84) Benannte Vertragsstaaten:
**DE ES FR GB IT**

(30) Priorität: **04.09.1993 DE 4329896**

(43) Veröffentlichungstag der Anmeldung:
**19.06.1996 Patentblatt 1996/25**

(73) Patentinhaber: **DEUTSCHE THOMSON-BRANDT GMBH**
**78048 Villingen-Schwenningen (DE)**

(72) Erfinder:
- **RIEGER, Martin**
  **D-78628 Rottweil (DE)**
- **ROTH, Sabine**
  **D-78087 Mönchweiler (DE)**

(74) Vertreter: **Wördemann, Hermes, Dipl.-Ing.**
**Deutsche Thomson-Brandt GmbH,**
**Licensing & Intellectual Property,**
**Göttinger Chaussee 76**
**30453 Hannover (DE)**

(56) Entgegenhaltungen:
**US-A- 4 004 141**
**US-A- 4 429 416**
**US-A- 5 057 717**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 716 783 B1

Printed by Jouve, 75001 PARIS (FR)

## Beschreibung

Es ist bekannt, einen Multiplizierer zur Verstärkungsregelung einzusetzen. An einen Eingang des Multiplizierers wird das Steuersignal angelegt, an den zweiten Eingang des Multiplizierers das Eingangssignal. Am Ausgang steht das Ausgangssignal an.

Bei bekannter Verstärkungsregelung wird das Ausgangssignal linear zum Steuersignal ausgegeben. Bei einem Eingangssignal von 1 Volt und einem Steuersignal zwischen 0 und 10 Volt sind lineare Verstärkungseigenschaften mit den Faktoren zwischen 0 und 100 realisierbar. Das heißt, bei 10 Volt Steuersignal ergibt sich eine Verstärkungsfaktor 100, bei 5 Volt Steuersignal ist der Verstärkungsfaktor 50. Werden die Verstärkungsfaktoren in dB ausgedrückt, entspricht der Verstärkungsfaktor 100 einem Wert von 40 dB und der Verstärkungsfaktor 50 dem Wert 34 dB. Ein linearer Verstärker ist also für die dB Linearirät ungeeignet, da in den unteren Regelbereichen sich die Änderungen im Ausgangssignal stark auswirken, hingegen in den oberen Regelbereichen die Änderungen der Steuergröße sich nicht mehr sehr auf das Ausgangssignal auswirken.

Im ZF-Bereich liegen die Verstärkungsfaktoren zwischen den Werten 1 und 1000. Diese Verstärkungsfaktoren sind gleichmäßig auf die Regelspannung zu verteilen, und deshalb ist eine dB-Linearität zwischen der Ausgangsspannung und dem Steuersignal anzustreben.

Es ist weiterhin aus US-A-5 057 717 und US-A-4 004 141 bekannt, eine Ausgangsspannung in logarithmischer Abhängigkeit zur Eingangsspannung zu ändern.

Der Erfindung liegt die Aufgabe zugrunde, einen gesteuerten multiplizierenden Verstärker dB linear auszulegen. Diese Aufgabe wird durch die im Anspruch 1 angegebenen Merkmale der Erfindung gelöst. Vorteilhafte Weiterbildungen der Erfindung sind in den Unteransprüchen angegeben.

Erfindungsgemäß sind den Eingängen des multiplizierenden Verstärkers Transistoren zur Ansteuerung vorgeschaltet. Diese Transistoren sind gleichzusetzen mit Transistorflächen auf einem Chip. Wird die Anzahl von vorgeschalteten Transistoren bzw. der Transistorflächen vor jedem Eingang des Multiplizieres gleich groß gewählt, arbeitet der Multiplizierer linear. Wird die Anzahl der Transistoren bzw. der Transistorflächen vor den Eingängen unterschiedlich gewählt, so ist bei geeignetem Aufteilungsverhältnis der Transistoren bzw. Transistorflächenverhältnisse eine dB-Linearisierung möglich.

Durch die Kontrolle des Stromes, welcher über die Transistoren den Eingängen des Multiplizieres zugeführt wird, ist die dB-Linearität genau einstellbar. Über die Reihenentwicklung ist das entsprechende Aufteilungsverhältnis von Transistoren und so eine geeignete Stromkontrolle ermittelbar.

Mit einer Steuereinheit wird zum einen die Steuerspannung in einen Strom umgewandelt und zum anderen Temperatureinflüsse kompensiert. Die Steuereinheit hat einen konstanten Anteil, welcher eine minimale Verstärung von 1 sicherstellt.

Eine bestmögliche dB Linearisierung ergibt sich bei dem Transistoraufteilungsverhältnis von 1:5. Vorteilhaft ist bei dieser Schaltung, daß mit geringem Aufwand eine dB Linearisierung ermöglicht wird.

Die Erfindung wird im folgenden anhand der Zeichnungen erläutert. Darin zeigen:

| | |
|---|---|
| Fig.1 | eine erfindungsgemäß ausgebildete Schaltung, |
| Fig.2 | die mit der Schaltung nach Fig. 1 realisierte gewonnene Kennlinie, |
| Fig.3 | eine Weiterbildung der erfindungsgemäß ausgebildeten Schaltung und |
| Fig.4 - 11 | Weiterbildungen der erfindungsgemäß ausgebildeten Schaltung. |

Fig. 1 zeigt einen dB linearisierten Multiplizierer. Die ZF-Spannung UE wird über einen Spannungsstromwandler 1, der aus den Transistoren T11, T12 und den Widerständen RE gebildet wird, in den Strom IE umgesetzt. Der Strom IE wird vom oberen Multiplizierer 2 abgeführt. An den Eingängen des Multiplizierers 2 liegt ein Gleichsignal U2 an. An dem Ausgang des Multiplizierers 2 steht die Ausgangsspannung VC an. Die Gleichspannung U1 liegt an der Basis der Transistoren T1, T2, T3, T4, T5, T6 an. Das Gleichsignal U2 änderet seinen Wert in Abhängigkeit von den Strömen Ia, Ib. Die Steuereinheit 3 wandelt die Steuerspannung VAGC in die Ströme Ia und Ib um. Der Strom Ia wird in Abhängigkeit von der Steuereinheit 3 von dem Transistor T1 abgeführt. Der Strom Ib wird in Abhängigkeit von der Steuereinheit 3 von den Transistoren T2, T3, T4, T5, T6 abgeführt. Die Ströme Ia, Ib werden über die Steuereinheit 3 in Abhängigkeit von der Steuerspannung VAGC gesteuert. Die Ströme Ia und Ib sind gegenläufig gerichtet, d.h. wenn ein Strom zunimmt, nimmt der andere Strom ab. Die Steuereinheit 3 hat einen konstanten Anteil Ikonst, mit dem eine Mindestverstärkung von 1 geschaffen wird. Das Gleichsignal U2 ist von den Strömen Ia, Ib abhängig und steuert den Multiplizierer derart an, daß der Strom IE geschaltet wird und einen Strom I1 bzw. einen Strom I2 zur Folge hat. Das Verhältnis von Ia zu Ib ist gleich dem Verhältnis wie I1 zu I2. Der Strom I1 bewirkt einen Spannungsabfall an dem Widerstand RC und liefert ein verstärktes Signal über die Spannung VC. Der Strom I2 bewirkt keinen Spannugsabfall an dem Widerstand RC und vermindert das verstärkte Signal über die Spannung VC. In der Weise wird die Signalaufteilung derart gesteuert, daß eine dB Linearität der Ausgangsspannung VC in Abhängigkeit von der ZF-Spannung UE

und der Steuerspannung VAGC ermöglicht wird.

Im folgenden wird beschrieben, wie sich das Aufteilungsverhältnis NT artgleicher Transistoren bezogen auf die Eingänge des Multiplizierers 2 auswirkt. Die abfallende Spannung zwischen Basis und Emitter steuert die Stromaufteilung bei den Transistoren T1 bis T6. Bei gleichem Aufteilungsverhältnis teilen sich alle Ströme gleich auf. Das heißt das Verhältnis von Ia zu Ib ist gleich dem Verhältnis wie I1 zu I2. Dieses ist die übliche Gleichstromaufteilung, welche die Hochfrequenzaufteilung des Stromes steuert, in diesem Fall mit dem Aufteilungsverhältnis 1:1. Bei einem anders gewählten Aufteilungsverhältnis wie z.B. 1:5 fließt bei der parallelen Anordnung von fünf Transistoren durch jeden einzelnen Transistor ein geringerer Teilstrom des Stromes Ib, und der Spannungsabfall wird nach einer besonderen Regel abnehmen.

Diese Regel ist gemäß der Diodencharakteristik

$$I_c = I_s{*}\exp(\frac{U_{BE}}{U_{Temp}})$$

aufzustellen, so daß sich die Formel ergibt

$$U_{BE} = U_{Temp}{*}\ln(\frac{I_C}{I_s}).$$

Is bedeutet dabei den Sperrsättigungsstrom der Diode. Es ist ersichtlich, daß die Basis/Emitterspannung sich in Abhängigkeit von der natürlichen Logarithmusfunktion des Stromverhältnisses ändert. Der Spannungssättigungsstrom ist somit abhängig von der Transistoranzahl und verteilt sich gleichmäßig auf die Transistoren T2 bis T6. Der Sperrsättigungsstrom Is ergibt sich aus den Transistoren T2 bis T6, und das Basis/Emitterverhältnis nimmt somit um den Faktor fünf ab. Bei gewältem Verhältnis 1:5 ergibt sich die Spannung

$$U_1 - U_2 = \left[\ln(\frac{I_a}{5*I_b})*U_{Temp}\right].$$

Somit geht das gewählte Verhälnis mit dem Logarithmus in die Formel ein. Das Verhältnis 1:5 d.h. T1 : T2, T3, T4, T5, T6 gewährleistet eine dB Linearität am Ausgang.

Fig. 2 zeigt den gewünschten Kurvenverlauf. In Abhängigkeit von der Steuerspannung VAGC [V] ist die Ausgangsspannung VC [dB] dargestellt. Der Kurvenverlauf a zeigt bei gewähltem Aufteilungsverhältnis NT=1:5 den dB linearen Verlauf zur Steuerspannnung VAGC. Der Kurververlauf b zeigt bei gewähltem Aufteilungsverhälnis NT 1:3 einen angenährt linearen Kurvenverlauf. Es ist deutlich ersichtlich, daß bei gewähltem Aufteilungsverhalnis NT=1:5 eine dB Linearität erreicht wird.

Fig. 3 zeigt eine modifizierte Schaltung, wobei die Änderung gegenüber Fig.1 in der Ausführungsform der Steuereinheit 3 liegt. Die Steuereinheit 3 besteht aus den Transistoren T13, T14, T15, T16, T17, T18, den Widerständen R1, R2, R3, R4, R5, R6, der Referenzspannungsquelle Uref und der Konstantstromquelle Ikonst. Die Steuereinheit 3 wandelt die Steuerspannung VAGC in die Ströme Ia und Ib um. Das unterschiedliche Aufteilungsverhältnis hat durch die unterschiedlichen Ströme einen Temperaturgang zur Folge, den es zu kompensieren gilt. Bei dieser Schaltungsanordnung sind die Ströme Ia, Ib so nachregelt, daß in Abhängigkeit von der Temperatur die Verstärkung konstant bleibt.

Fig.4 zeigt einen Regelbaren Verstärker mit abgestimmten Emitterflächen. Der Verstärker besteht aus drei gekoppelten Differenzverstärkern n1, n2, nc. Die Emitterflächen der Transistoren sind unterschiedlich. Der Differenzverstärker nc, im Zentrum, hat Emitterflachen nc*Ae, wobei nc eine ganze Zahl und Ae die Emitterflächeneinheit ist (z.B. 5µm*5µm). Die beiden äußeren Differenzverstärker n1, n2 weisen Emitterflächen n1*Ae, n2*Ae bzw. n2*Ae, n1*Ae auf. Die Steuerströme der Differenzverstärker sind Ia, Ib und Ic. Der Kollektorstrom Ic1 ergibt sich zu.

$$i_{c1} = i_c{*}\frac{e^x}{1+e^x} + i_a{*}\frac{\frac{n_1}{n_2}{*}e^x}{1+\frac{n_1}{n_2}{*}e^x} + i_b{*}\frac{\frac{n_2}{n_1}{*}e^x}{1+\frac{n_2}{n_1}{*}e^x} \quad mit\ x = \frac{V_e}{2V_T}$$

Die Spannungsverstärkung Av= va/ve ergibt sich zu

$$Av = \frac{di_{c1}}{dx} * R_k$$

Die Ableitung $\frac{dAv}{dx}$ ist ein Maß für die Linearität der Verstärkung. Die Verstärkung Av ist demnach aussteuerungsabhängig. Wenn Ia = Ib ist, ergibt sich

$$\frac{dAv}{dx} = 2R_k\left[i_c * \frac{e^X}{(1+e^X)^2} + io\frac{2e^X + 4e^{2X} + 2e^{3X}}{1+4e^X + 6e^{2X} + 4e^{3X} + e^{4X}}\right] \text{ mit ia = ib = io}$$

Ziel des linearen Verstärkerentwurfes ist es, mit der Spannungsverstärkung Av = const eine möglichst grosse Aussteuerung x zu erreichen. Mit mathematischen Optimierungsverfahren können nun Ia, Ib, Ic, n1, n2 und nc so bestimmt werden, daß dies erreicht wird.

Fig.5, Kurve a zeigt den Verlauf der Spannungsverstärkung Av (x) für einen Verstärker, der nur aus dem mittleren Differenzverstärker nc besteht. Kurve b zeigt einen Verstärker, der nur aus den beiden äußeren Differenzverstärkern n1 besteht. Kurve c zeigt einen Verstärker, der aus allen 3 Differenzverstärkern n1, n2, nc besteht. Die Lösung nach Kurve 2c zeigt eine deutlich bessere Linearität im gesamten Aussteuerbereich. Die Aussteuergrenze bei einer zulässigen Verbesserung von 1% ist in Tabelle 1 für die verschiedenen Versionen Kurve a, b und c aufgeführt.

Tabelle 1:

| Schaltung/Kurve | Aussteuergrenze für Klirrfaktor k≤1% |
|---|---|
| nc / a | $x \leq 0.2$ |
| n1 / b | $x \leq 1.0$ |
| n1,n2,nc / c | $x \leq 1.8$ |
| ideal | $x \to \infty$ |

Die neue Lösung Kurve c zeigt gegenüber den bekannten Lösungen Kurve a und b in etwa den doppelten Aussteuerbereich.

Fig. 6 zeigt eine Schaltung mit einer temperaturabhängigen Verstärkung, wenn die Steuerströme mit Hilfe eines VT-Generators porportional zur Temperatur ansteigen.

Fig. 7 zeigt ein weiteres Ausführungsbeispiel. Der Verstärker besteht aus vier in Kette geschalteten Verstärkern, welche monolithisch integriert sind. Die maximal zulässige Eingangspannung Vin für einen Klirrfaktor k≤1% beträgt 60 mVpp. Die Verstärkung kann von 0dB bis 60dB variiert werden. Die auf den Verstärker bezogenen Rauschspannungsschichte ist 5nV/√. Die Bandbreite des Verstärkers ist größer als 120 MHz.

Fig. 8 zeigt eine Vervielfachung des Aussteuerbereiches. Durch Einfügen von m Dioden in die Emitterleitung der Differenzverstärker vergrößert sich der Aussteuerbereich auf das m-fache.

Fig. 9 zeigt eine Schaltung zur Vergrößerung der Bandbreite. Mittels einer Kascodeschaltung kann die parasitäre Kollektor-Substrat-Kapazität Cs unwirksam gemacht und damit die Bandbreite erhöht werden.

Fig. 10 zeigt eine eingangspannungabhängige Verstärkung. Durch geeignete Wahl von Differenzverstärkern n1, n2, nc, ia, ib, und ic lassen sich fast beliebig geformte Verstärkungskurven erreichen. Eine weitere Variante ergibt sich durch Kreuzen der Kollektorleitungen.

Fig. 11 zeigt einen weiteren Differenzverstärker 10. Durch Hinzufügen eines weiteren Differenzverstärkers 10 läßt sich der Aussteuerbereich, in dem der Verstärker linear ist, erweitern.

## Patentansprüche

1. Verstärkerstufe mit einer Verstärkung die sich linear mit dem Logarithmus einer Steuerspannung (VAGC) ändert, so daß eine Änderung der Steuerspannung (VAGC) um ein bestimmtes Verhältnis einer Änderung der Verstärkung um dasselbe Verhältnis in dB entspricht, mit einem durch die Steuerspannung (VAGC) gesteuerten Multiplizieren auf Differenzverstärker-Basis, **dadurch gekennzeichnet,** daß die Steuerspannung (VAGC) einer Steuereinheit (3) zugeführt wird und zwischen der Steuereinheit (3) und den Differenzverstärker-Eingängen des Multiplizieres (2) Transistoren (T1, T2, T3, T4, T5, T6) angeordnet sind und daß die Transistoren durch zahlenmäßiges Aufteilungsverhältnis (NT) auf die Differenzverstärker-Eingänge des Multiplizierers (2) verteilt sind.

2. Verstärkerstufe nach Anspruch 1, **dadurch gekennzeichnet,** daß eine Steuereinheit (3) vorgesehen ist, die die Steuerspannung (VAGC) in einen Strom (Ia, Ib) umwandelt.

3. Verstärkerstufe nach Anspruch 2, **dadurch gekennzeichnet,** daß die Steuereinheit (3) die Ströme (Ia, Ib) so nachregelt, daß die Verstärkung über der Temperatur konstant bleibt.

4. Verstärkerstufe nach Anspruch 1, **dadurch gekennzeichnet**, daß das Aufteilungsverhältnis der Transistoren (T1, T2, T3, T4, T5, T6) vor den Eingängen des Multiplizieres (2) etwa den Wert 1:5 hat.

5. Verstärkerstufe nach Anspruch 1, **dadurch gekennzeichnet,** daß die Transistoren durch entsprechende Transistorflächen auf einem Chip gebildet werden.

6. Verstärkerstufe nach Anspruch 1, **dadurch gekennzeichnet**, daß die Verstärkerstufe aus Differenzverstärkern (nc) gebildet wird und die Spannungsverstärkung (Av) sich aus der Ausgangsspannung (Vc, Va) zur Eingangsspannung (VAGC, VE) ergibt und daß durch Koppeln von Differenzverstärkern (nc) bei konstanter Spannungsverstärkung (Av) der Aussteuerbereiches vergrößert wird.

7. Verstärkerstufe nach Anspruch 6, **dadurch gekennzeichnet**, daß der Aussteuerbereich durch Einfügen von m Dioden in die Emitterleitung der Differenzverstärker sich um das m-fache vergrößert.

**Claims**

1. Amplifier stage having a gain which varies linearly with the logarithm of a control voltage (VAGC) so that a variation of said control voltage (VAGC) by a defined ratio corresponds to a variation of the amplification by the same ratio in dB, including a multiplier controlled by said control voltage (VAGC) on the basis of differential amplifiers, characterised in that said control voltage (VAGC) is fed to a control unit (3) and that transistors (T1, T2, T3, T4, T5, T6) are arranged between said control unit (3) and the differential amplifier inputs of said multiplier (2) and that said transistors are distributed by a numerical distribution ratio (NT) on the differential amplifier inputs of said multiplier (2).

2. Amplifier stage according claim 1, characterised in that a control unit (3) is provided converting said control voltage (VAGC) into a current (Ia, Ib).

3. Amplifier stage according claim 2, characterised in that said control unit (3) controls said currents (Ia, Ib) in such a way that the gain remains constant with temperature.

4. Amplifier stage according claim 1, characterised in that the distribution ratio of said transistors (T1, T2, T3, T4, T5, T6) in front of the inputs of said multiplier (2) has the value of approximately 1:5.

5. Amplifier stage according claim 1, characterised in that said transistors are formed by corresponding transistor areas on a chip.

6. Amplifier stage according claim 1, characterised in that said amplifier stage is formed by differential amplifiers (nc) and that the voltage gain (Av) is derived from the output voltage (Va) relativ to the input voltage (VE) and that the modulation range is increased by coupling of differential amplifiers (nc) with constant voltage gain (Av) of the modulation range.

7. Amplifier stage according claim 6, characterised in that the modulation range is increased m-fold by the insertion of m diodes intos the emitter lead of the differential amplifiers.

**Revendications**

1. Etage d'amplificateur avec une amplification qui varie de façon linéaire avec le logarithme d'une tension de commande (VAGC), de sorte qu'une modification de la tension de commande (VAGC) dans certaines proportions

entraîne un changement de l'amplification dans les mêmes proportions en dB, avec un multiplicateur sur la base d'un amplificateur différentiel piloté par la tension de commande (VAGC), caractérisé en ce que la tension de commande (VAGC) est amenée à une unité de commande (3) et en ce que des transistors (T1, T2, T3, T4, T5, T6) sont agencés entre l'unité de commande (3) et les entrées de l'amplificateur différentiel du multiplicateur (2) et en ce que les transistors sont répartis entre les entrées de l'amplificateur différentiel du multiplicateur (2) grâce à une répartition en nombre (NT).

**2.** Etage d'amplificateur selon la revendication 1, caractérisé en ce qu'il est prévu une unité de commande (3) qui transforme la tension de commande (VAGC) en un courant (Ia, Ib).

**3.** Etage d'amplificateur selon la revendication 2, caractérisé en ce que l'unité de commande (3) rajuste les courants (Ia, Ib) de manière à ce que l'amplification reste constante en température.

**4.** Etage d'amplificateur selon la revendication 1, caractérisé en ce que le rapport de répartition des transistors (T1, T2, T3, T4, T5, T6) possède environ la valeur 1:5 avant les entrées du multiplicateur (2).

**5.** Etage d'amplificateur selon la revendication 1, caractérisé en ce que les transistors sont formés sur une puce grâce à des surfaces de transistor correspondantes.

**6.** Etage d'amplificateur selon la revendication 1, caractérisé en ce que l'étage d'amplificateur est constitué d'amplificateurs différentiels (nc) et en ce que l'amplification de tension (Av) résulte de la tension de sortie (Va) par rapport à la tension d'entrée (VE) par accouplement d'amplificateurs différentiels (nc) et en ce que la plage de modulation est agrandie lorsque l'amplification de tension (Av) est constante.

**7.** Etage d'amplificateur selon la revendication 6, caractérisé en ce que la plage de modulation est agrandie m fois par l'insertion de m diodes dans la ligne d'émetteur des amplificateurs différentiels.

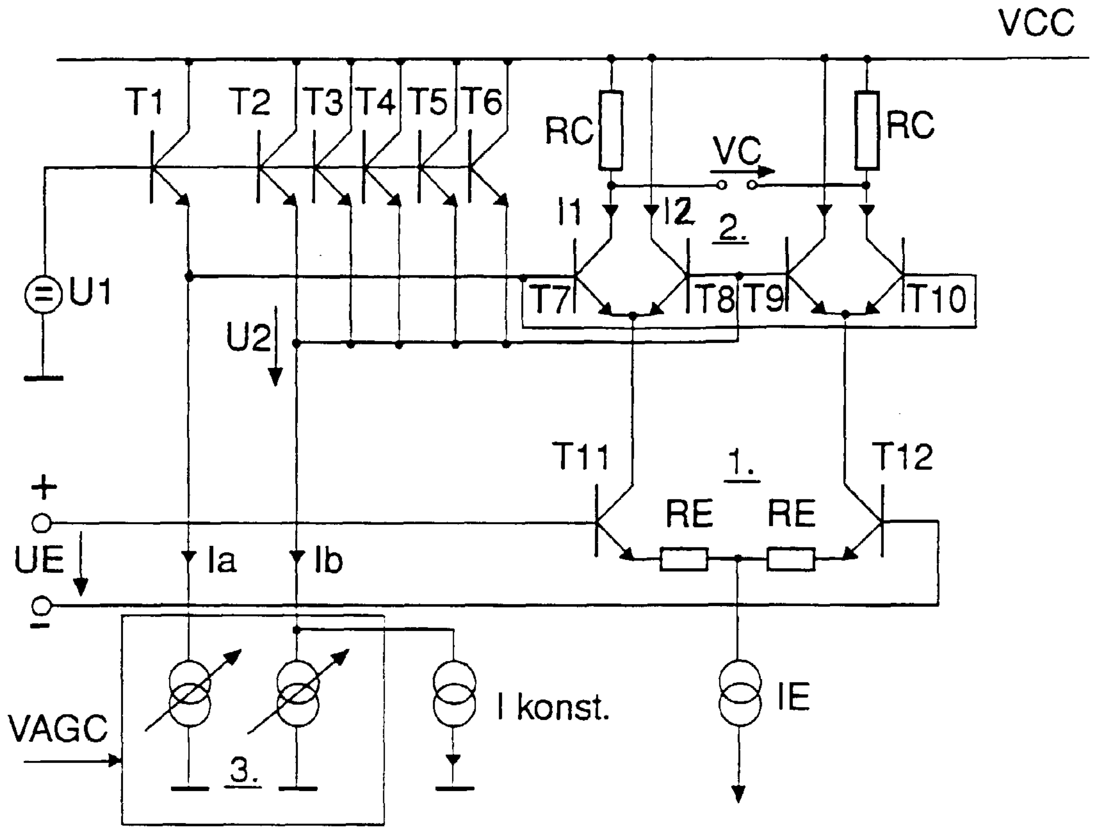
VCC
T1
T2
T3
T4
T5
T6
RC
RC
VC
I1
I2
2.
U1
T7
T8
T9
T10
U2
T11
1.
T12
+
RE
RE
UE
Ia
Ib
-
VAGC
3.
I konst.
IE

Fig.1

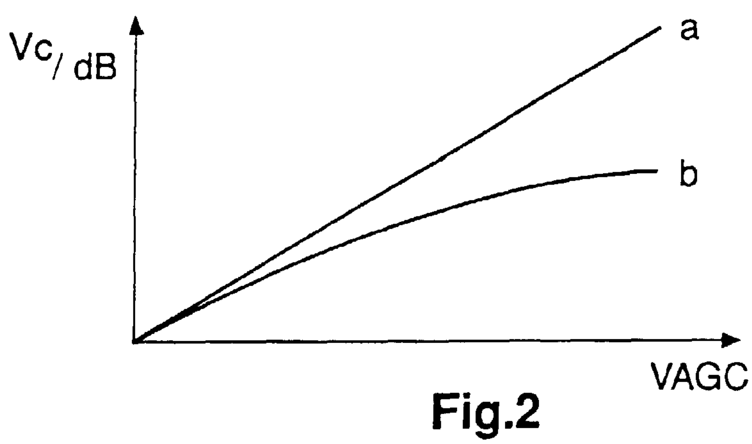
Vc/ dB
a
b
VAGC

Fig.2

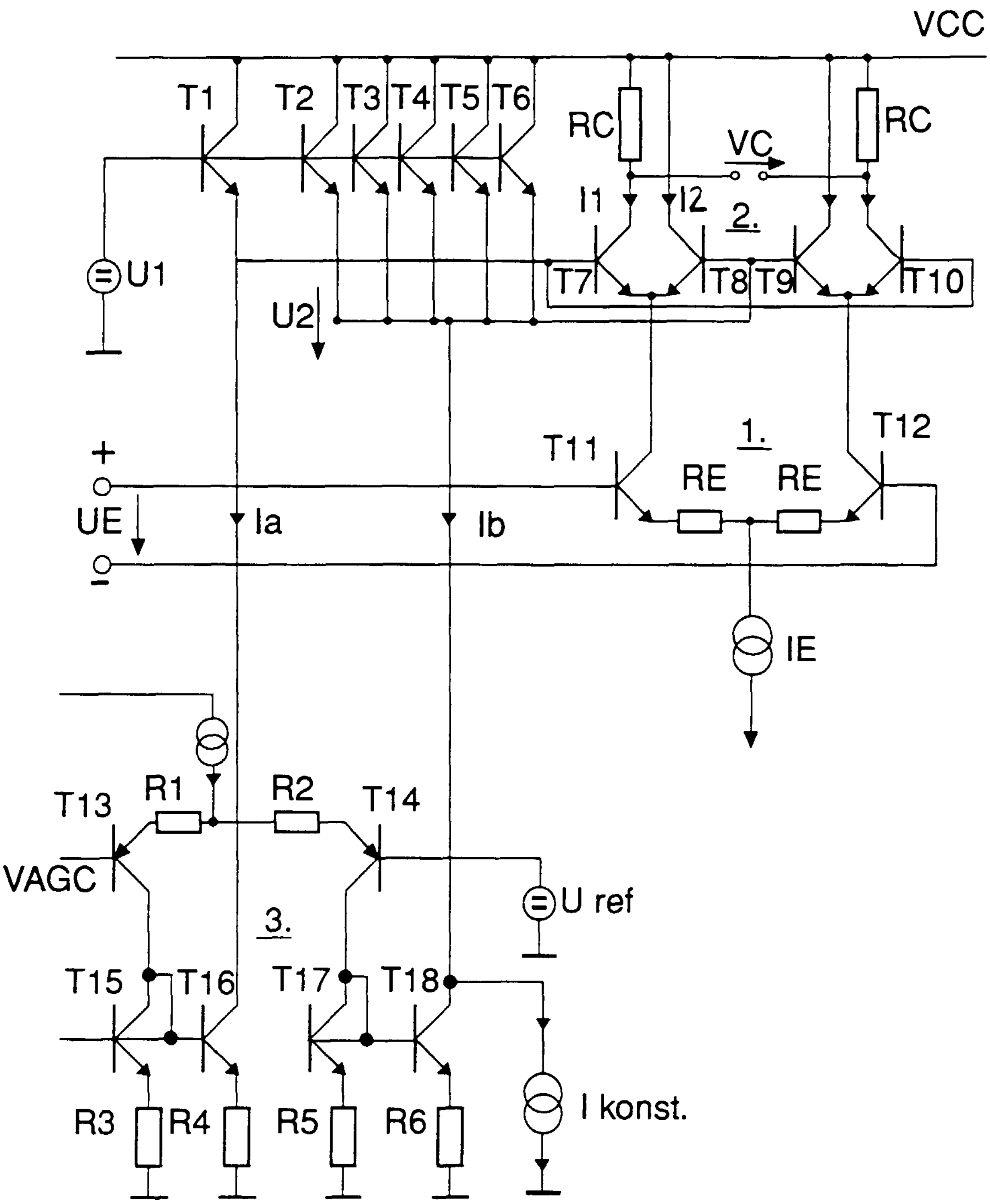

VCC
T1
T2
T3
T4
T5
T6
RC
RC
VC
I1
I2
2.
U1
T7
T8
T9
T10
U2
T11
1.
T12
+
RE
RE
UE
Ia
Ib
-
IE
R1
R2
T13
T14
VAGC
U ref
3.
T15
T16
T17
T18
R3
R4
R5
R6
I konst.


Fig.3

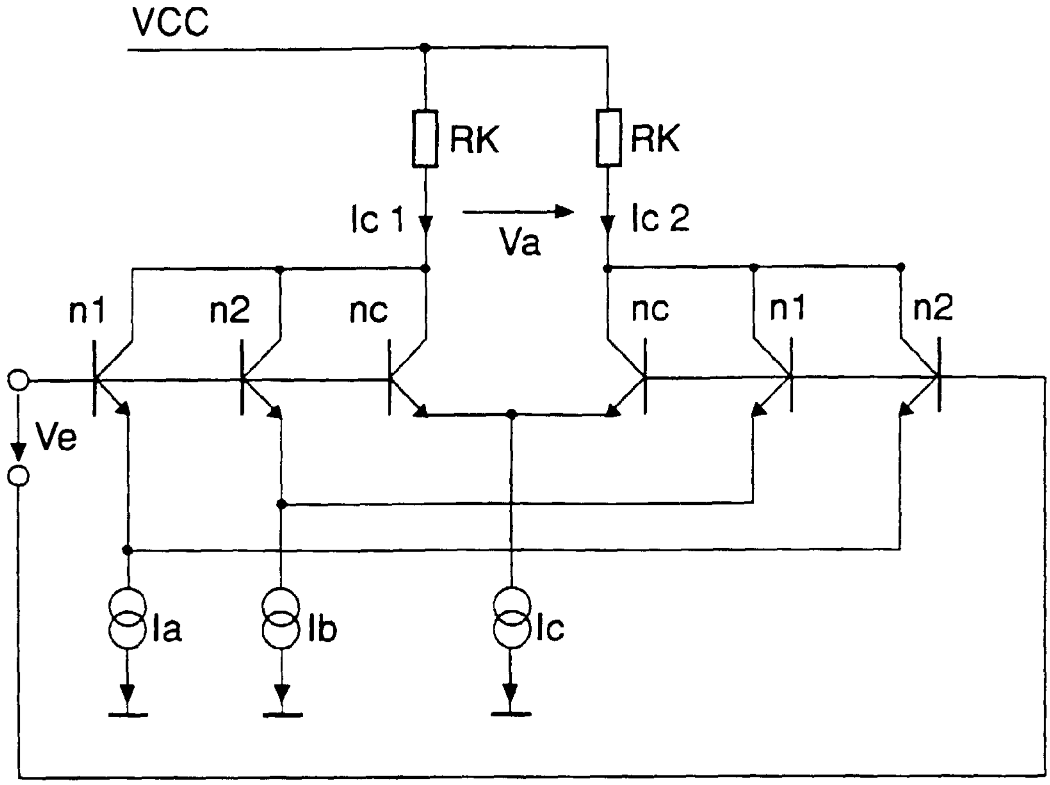


Fig.4

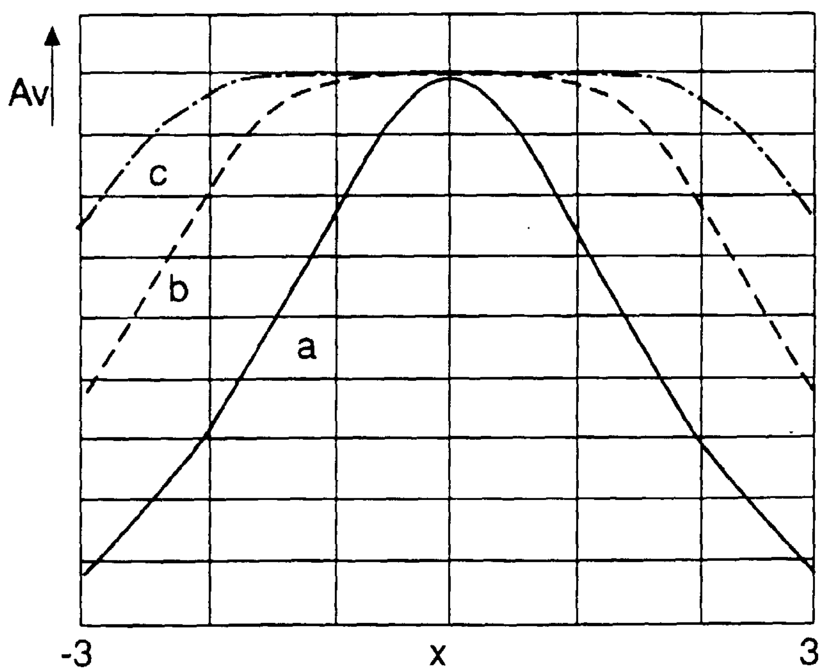


Fig.5

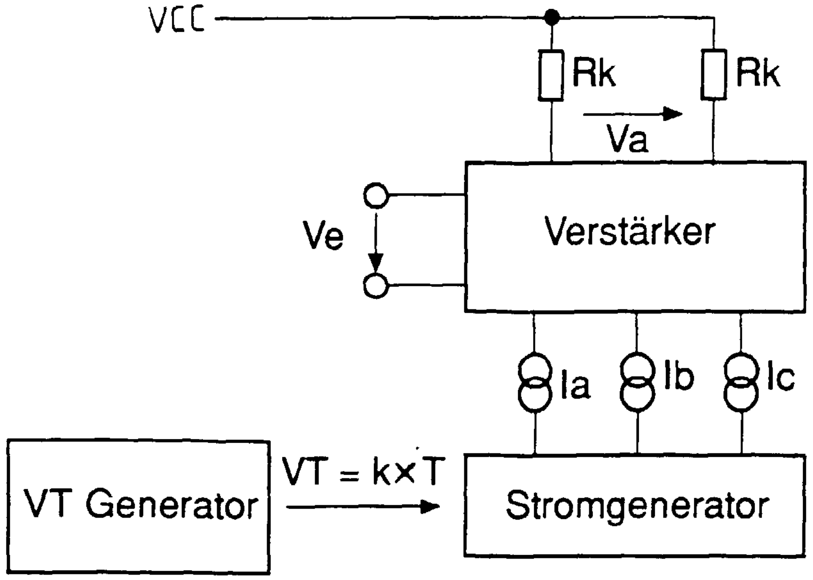
VCC
Rk
Rk
Va
Ve
Verstärker
Ia
Ib
Ic
VT Generator
VT = k×T
Stromgenerator

Fig.6

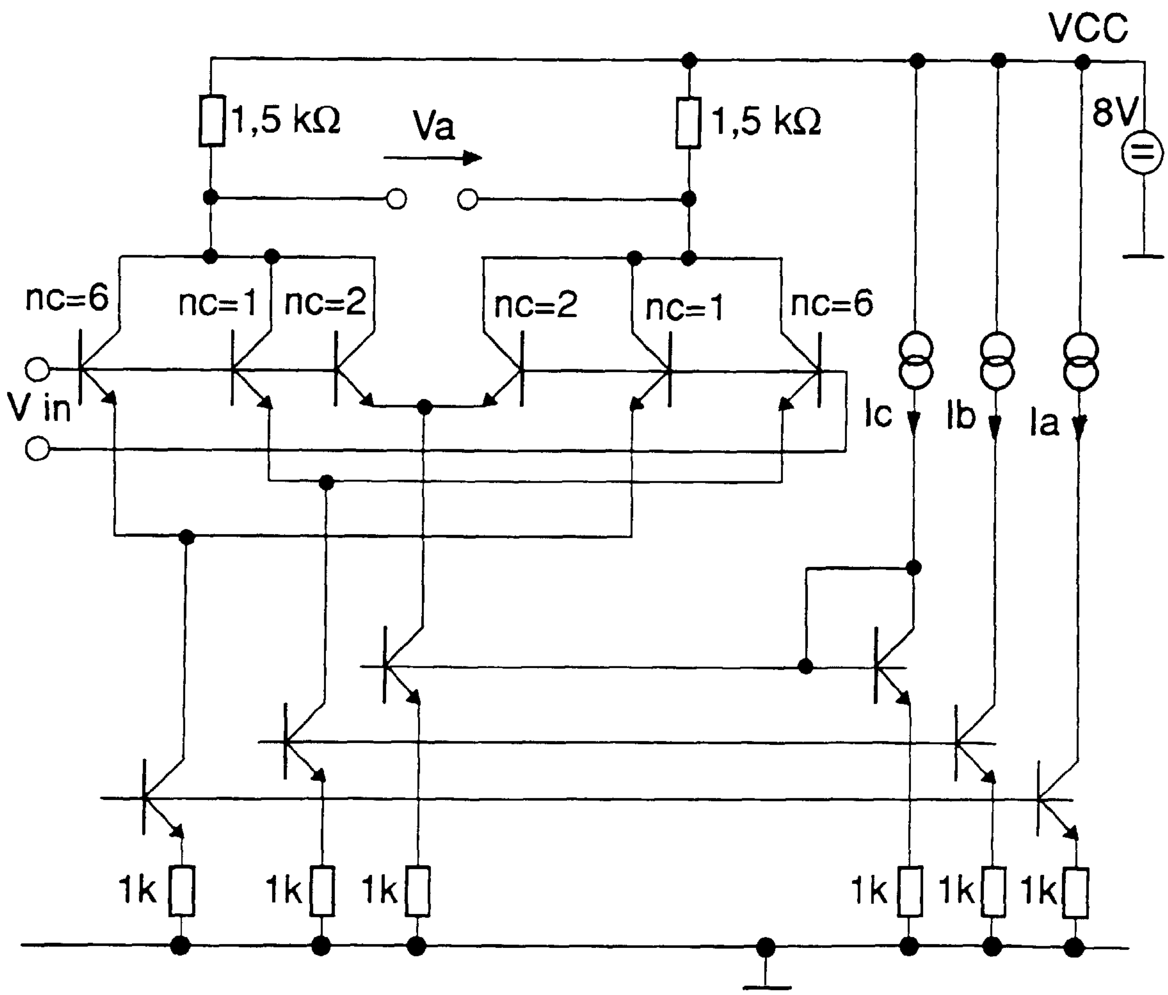
VCC
1,5 kΩ
Va
1,5 kΩ
8V
nc=6
nc=1
nc=2
nc=2
nc=1
nc=6
V in
Ic
Ib
Ia
1k
1k
1k
1k
1k
1k

Fig.7

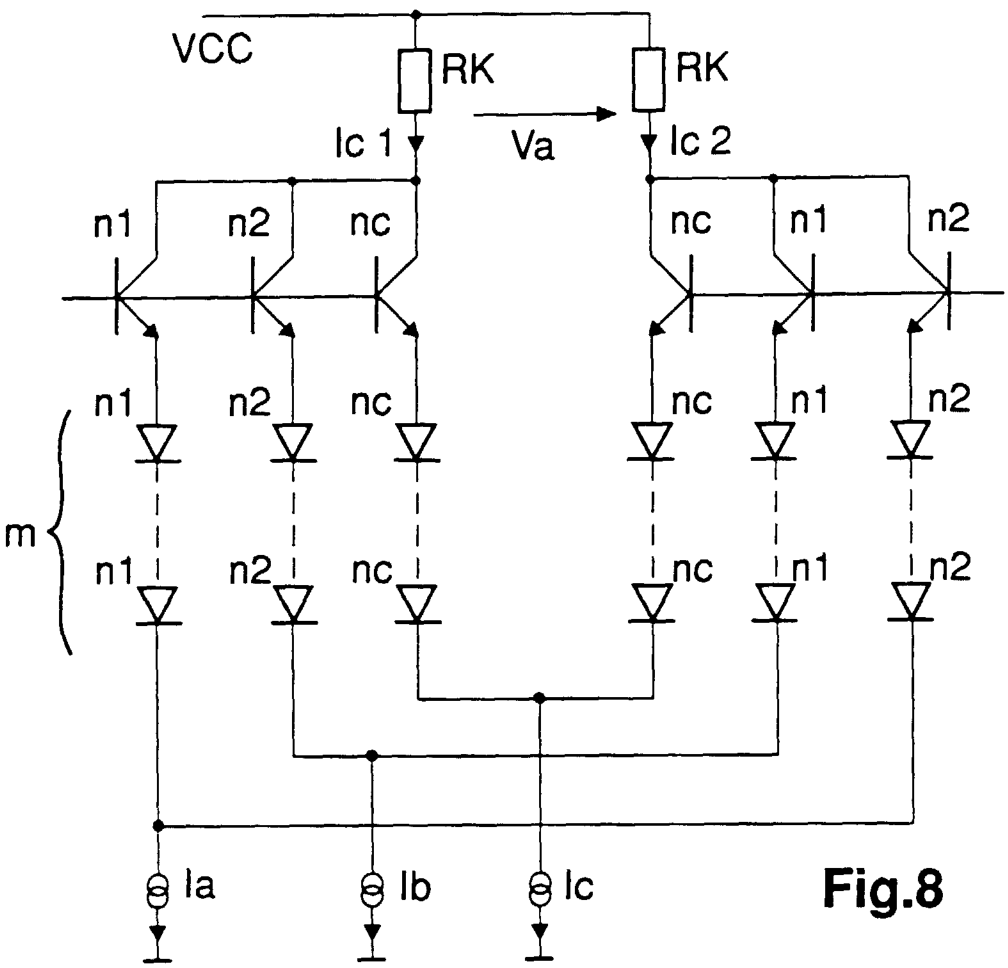
VCC
RK
RK
Ic 1
Va
Ic 2
n1
n2
nc
nc
n1
n2
m
Ia
Ib
Ic

Fig.8

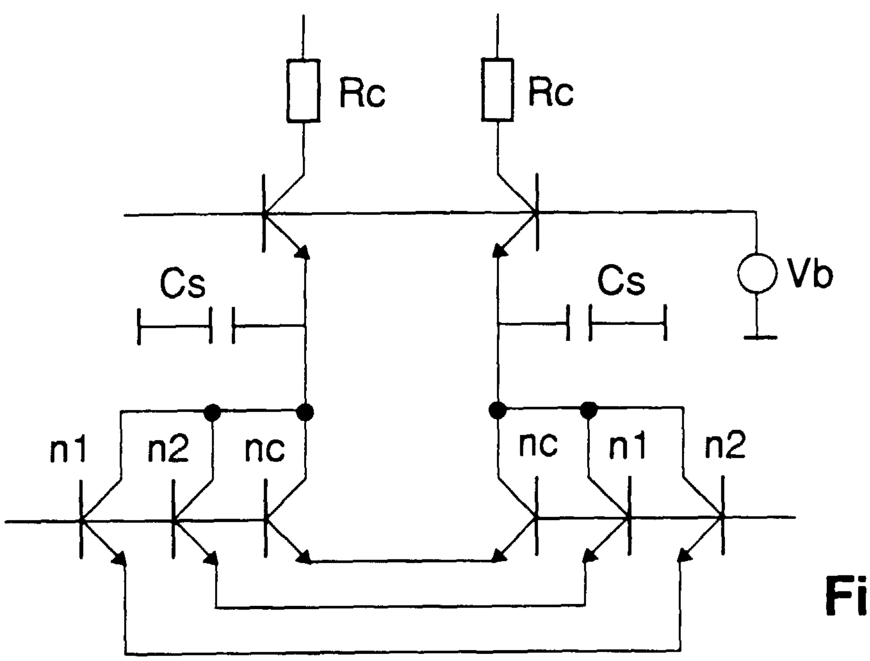
Rc
Rc
Cs
Cs
Vb
n1
n2
nc
nc
n1
n2

Fig.9

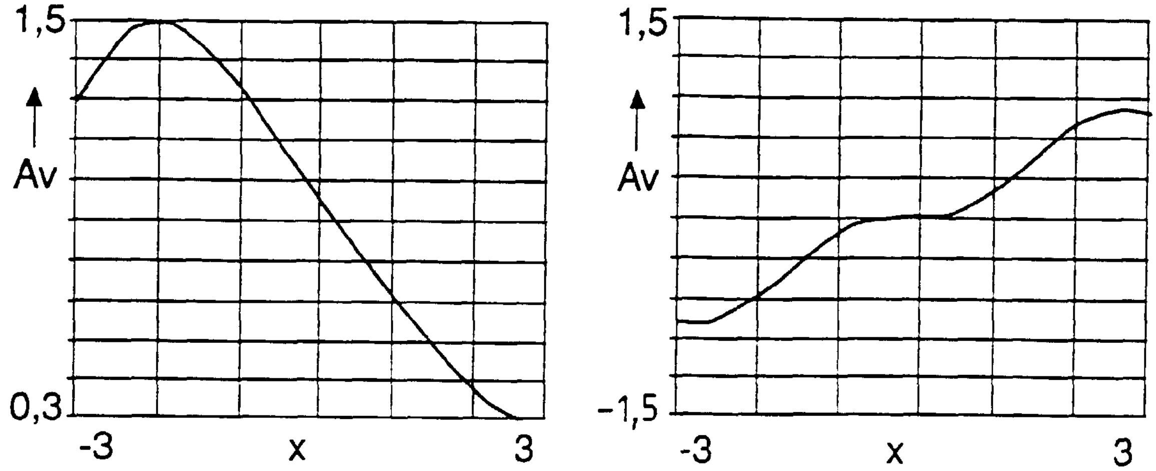
1,5
Av
0,3
-3
x
3
1,5
Av
-1,5
-3
x
3

Fig.10

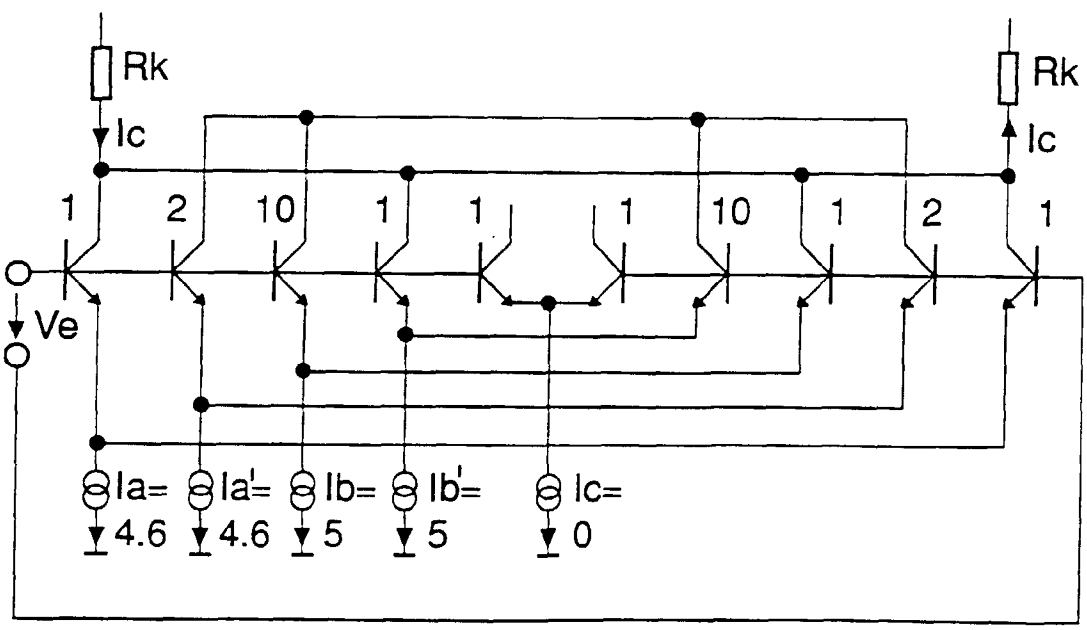
Rk
Ic
Rk
Ic
1
2
10
1
1
1
10
1
2
1
Ve
Ia=
4.6
Ia'=
4.6
Ib=
5
Ib'=
5
Ic=
0

Fig.11